# FASCICULE DE BREVET EUROPEEN

(11) **EP 2 926 151 B1**
(45) Date de publication et mention de la délivrance du brevet: **09.11.2016**
(21) Numéro de dépôt: 13812007.6
(22) Date de dépôt: 28.11.2013
(51) Int. Cl.: G01R 15/14, G01R 21/133, H02H 1/00

(54) **DISPOSITIF DE MESURE D'AU MOINS UNE GRANDEUR ÉLECTRIQUE D'UN COURANT CIRCULANT DANS UN APPAREIL ÉLECTRIQUE**
VORRICHTUNG ZUR MESSUNG VON MINDESTENS EINER ELEKTRISCHEN GRÖSSE EINES STROMES IN EINER ELEKTRISCHEN VORRICHTUNG
DEVICE FOR MEASURING AT LEAST ONE ELECTRICAL QUANTITY OF A CURRENT CIRCULATING IN AN ELECTRICAL APPARATUS

(30) Priorité: 28.11.2012 FR 1203221
(43) Date de publication de la demande: 07.10.2015
(73) Titulaire: Schneider Electric Industries SAS, 92500 Rueil-Malmaison (FR)
(72) Inventeur: TIAN, Simon, F-38320 Eybens (FR); AMBLARD, Jean-Yves, F-38450 Le Gua (FR); BUFFART, Sébastien, F-38210 Tullins (FR)
(74) Mandataire: Hecké, Gérard
(86) Numéro de dépôt international: PCT/FR2013/000312
(87) Numéro de publication internationale: WO 2014/083247

(56) Documents cités:
- EP-A1- 2 402 769
- WO-A1-2008/028431
- GB-A- 2 276 728
- GB-A- 2 300 724
- US-A- 5 548 523
- US-A1- 2004 008 461
- US-A1- 2008 284 410
- US-A1- 2010 264 944

## Description

### Domaine technique de l'invention

L'invention concerne la mesure d'une grandeur électrique d'un courant circulant dans un appareil électrique, en particulier l'énergie et la puissance électrique.

### État de la technique

Actuellement, on utilise des appareils de mesure, appelés compteurs d'énergie, pour mesurer des courants, des tensions, et en particulier l'énergie électrique, ou encore la puissance électrique, consommées ou fournies par un système électrique. Le système électrique comporte un ou plusieurs appareils électriques, et généralement au moins un appareil de protection électrique. Ces appareils électriques sont généralement installés au sein d'une armoire électrique qui ne comporte pas beaucoup d'espace pour loger d'autres équipements de mesure. Il est donc intéressant de fournir des appareils de mesure qui soient suffisamment compacts tout en étant robustes et efficaces.

En outre, les appareils de protection électrique peuvent avoir différentes configurations selon le type de distribution du courant, triphasée ou monophasée, qui circule dans le système à protéger. En particulier, les appareils de protection en triphasé sont configurés pour être connectés à trois conducteurs de phase, et éventuellement à un conducteur parcouru par un courant de neutre, et les appareils de protection en monophasé sont configurés pour être connectés à un conducteur ou à deux conducteurs si le neutre est distribué. Il est donc utile de fournir un dispositif de mesure qui soit adapté aux différentes configurations des appareils de protection électriques.

Par exemple, des appareils de protection électrique comportent des dispositifs de mesure de l'énergie qui sont intégrés à l'intérieur des boîtiers des appareils. Mais ces dispositifs de mesure sont dépendants du type, monophasé ou triphasé, de l'appareil auquel ils sont intégrés, et ne sont pas compatibles avec d'autres types d'appareils de protection.

D'autres appareils de mesure peuvent être couplés en amont ou en aval d'un appareil de protection, sur les conducteurs qui amènent le courant, ou sur les conducteurs qui distribuent le courant depuis l'appareil de protection. Mais ces appareils sont encombrants et ils sont difficiles à monter dans l'armoire électrique contenant l'appareil de protection.

De manière générale, un appareil de protection électrique, tel un disjoncteur, comporte des conducteurs de phase connectés sur des bornes d'entrée du disjoncteur et des conducteurs de phase connectés sur des bornes de sortie du disjoncteur. En outre, les disjoncteurs comportent généralement un conducteur de neutre connecté sur une borne de référence d'entrée et un conducteur de neutre connecté sur une borne de sortie du disjoncteur. Plus particulièrement, chaque borne d'entrée est située en regard d'une borne de sortie du disjoncteur de sorte que la borne de référence d'entrée est située du même côté du disjoncteur que la borne de référence de sortie. Selon la configuration du disjoncteur, le conducteur de neutre peut être placé à gauche ou à droite des conducteurs de phase. Mais il n'existe pas un même dispositif de mesure adapté pour être monté, soit en amont du disjoncteur avec le conducteur de neutre d'entrée situé sur un côté du disjoncteur, soit en aval avec le conducteur de neutre de sortie situé du même côté du disjoncteur.

On peut citer la demande de brevet européen EP2184808 qui décrit un connecteur modulaire pour des connexions électriques muni d'un système d'ancrage extérieur pour fixer des connecteurs entre eux. Le système d'ancrage comprend des rainures et languettes de raccord. La demande de brevet européen EP0223622 décrit un dispositif d'assemblage côte à côte de blocs modulaires d'appareillage électrique. Les boîtiers des blocs modulaires sont accouplés au moyen de deux crochets qui s'emboîtent par encliquetage. La demande de brevet EP0986136 décrit l'utilisation d'un loquet glissant pour fixer des modules électriques entre eux.

On peut également citer les demandes de brevet JP2004031228, CN201780935, CN2687824, FR2066738, et US4809132 qui divulguent l'utilisation de connexions en forme de queue d'aronde pour connecter des modules électriques entre eux. Les demandes de brevet américain US4347294 et US7364476 qui divulguent des connexions à l'aide d'un ergot mobile.

La demande internationale WO200252697 décrit un stator dont le noyau comprend une fente en queue d'aronde recevant une tige reliée à la carcasse du stator. Le stator comporte en outre un ressort couplé entre la fente et la tige pour fournir un trajet de contact électrique entre le noyau et la carcasse du stator.

On peut encore citer la demande de brevet américain US7359809 qui décrit un dispositif de mesure d'un courant de charge d'un conducteur. La demande de brevet US6950292 qui décrit un équipement pour contrôler l'énergie électrique d'un conducteur comprenant des capteurs de courant intégrés dans l'équipement. La demande de brevet américain US7330022 qui décrit un système de contrôle de puissance comprenant plusieurs capteurs.

Mais aucun de ces documents ne prend en compte les différentes positions des conducteurs de neutre dans un disjoncteur.

Par ailleurs, la demande de brevet américain US2007/0069715 décrit un système de mesure modulaire comprenant un module de calcul d'un courant, un module de courant pour mesurer un courant et un module de tension, dans lequel le module de courant est séparé du module de calcul. La demande de brevet américain US2010/0207604 décrit un dispositif de mesure d'une puissance électrique consommée comprenant un transformateur de courant amovible. La demande internationale WO02/065144 décrit un système de contrôle de puissance comprenant un module de mesure de puissance détachable du système de contrôle. La demande de brevet japonais JP2003222645 décrit, quant à elle, un dispositif de mesure de puissance d'un circuit de charge comprenant un équipement principal pour fournir une tension d'alimentation, un capteur de courant, et des équipements de mesure séparés du dispositif pour calculer la puissance consommée. Mais ces documents séparent les moyens de mesure des moyens de calcul des grandeurs, ce qui rend les dispositifs moins compacts.

US 2008/284410 A1 divulgue des modules de courant et de tension autour de l'isolant d'un conducteur. GB 2 276 728 divulgue un système de mesure modulaire comprenant des fiches terminales d'entrée.

En outre, certains équipements électriques, comme des capteurs de courant différentiel, peuvent être montés en amont, par exemple en haut du disjoncteur, ou en aval, par exemple en bas du disjoncteur. Selon la configuration électrique du disjoncteur, l'encombrement en amont ou en aval du disjoncteur n'est pas le même.

Il est donc intéressant de fournir un dispositif de mesure adapté pour être monté, soit en bas d'un disjoncteur quand il s'agit d'un disjoncteur de départ, soit en haut d'un disjoncteur quand il s'agit d'un disjoncteur d'arrivée.

### Objet de l'invention

L'objet de l'invention consiste à remédier à ces inconvénients, et plus particulièrement à fournir un dispositif de mesure adapté à différents appareils électriques et qui puisse être monté facilement en amont ou en aval d'un appareil électrique.

Un autre objet de l'invention est de fournir un dispositif compact pour être facilement intégré au sein d'une armoire électrique dans laquelle est monté l'appareil électrique.

Selon un aspect de l'invention, il est proposé un dispositif de mesure d'au moins une grandeur électrique d'un courant circulant dans un appareil électrique, comme défini par la revendication 1.

Ainsi on fournit un dispositif de mesure compact qui peut être monté en haut ou en bas d'un disjoncteur sans prendre de la place supplémentaire dans l'armoire électrique. En outre, on fournit un dispositif qui peut être monté sur les bornes de connexion d'un appareil électrique, c'est-à-dire au plus près de l'appareil, pour permettre un montage du dispositif sur l'appareil et une connexion du dispositif avec les conducteurs reliés à l'appareil en une seule opération.

Le module principal peut comporter trois orifices traversant les première et deuxième faces et destinés à être traversés par respectivement trois conducteurs reliés électriquement à trois bornes de l'appareil électrique, chaque orifice traversant comprenant des moyens de connexion configurés pour être reliés électriquement à la borne reliée au conducteur traversant l'orifice, les moyens de mesure de tension étant en outre configurés pour mesurer les tensions respectives entre les trois bornes et la borne de référence.

Un tel module auxiliaire peut être monté aussi bien à gauche ou à droite du module principal afin de répondre aux différentes configurations des appareils électriques.

Le module auxiliaire peut en outre comporter deux faces latérales orientées sensiblement perpendiculairement aux première et deuxième faces du module auxiliaire et comprenant respectivement deux fentes pour le passage d'une connexion auxiliaire située en saillie du module auxiliaire, et le dispositif de mesure comporte un obturateur pour obturer la fente située en regard d'une première connexion auxiliaire rétractée lorsque la deuxième connexion auxiliaire est connectée à une connexion principale.

Le module auxiliaire peut comporter des moyens de liaisons mobiles reliant électriquement les moyens de connexion du module auxiliaire avec l'élément conducteur monté mobile en translation.

Les moyens de liaisons mobiles peuvent être un fil conducteur ou une lame ressort.

Chaque connexion auxiliaire peut être configurée pour établir une connexion mécanique avec au moins une connexion principale de façon à solidariser le module auxiliaire avec le module principal.

Les connexions principales peuvent être reliées électriquement entre elles par une barre conductrice ou un circuit électronique.

L'appareil électrique peut être un appareil de protection électrique, et les bornes de l'appareil correspondent aux bornes d'entrée ou aux bornes de sortie du courant circulant dans l'appareil.

Les moyens de connexion de chaque orifice traversant peuvent comporter une fiche conductrice faisant saillie de l'orifice traversant de manière à coopérer avec la borne reliée au conducteur qui traverse l'orifice traversant pour maintenir le module principal sur l'appareil.

Le module principal peut comporter en outre des moyens de mesure de courant configurés pour mesurer le courant circulant dans chaque conducteur traversant les orifices traversant du module principal.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- la figure 1, illustre schématiquement une vue en perspective d'un mode de réalisation d'un dispositif de mesure selon l'invention ;
- la figure 2, illustre schématiquement une vue en coupe d'un autre mode de réalisation du dispositif de mesure ; et
- la figure 3, illustre schématiquement une vue en coupe d'un autre mode de réalisation du dispositif de mesure.

### Description détaillée

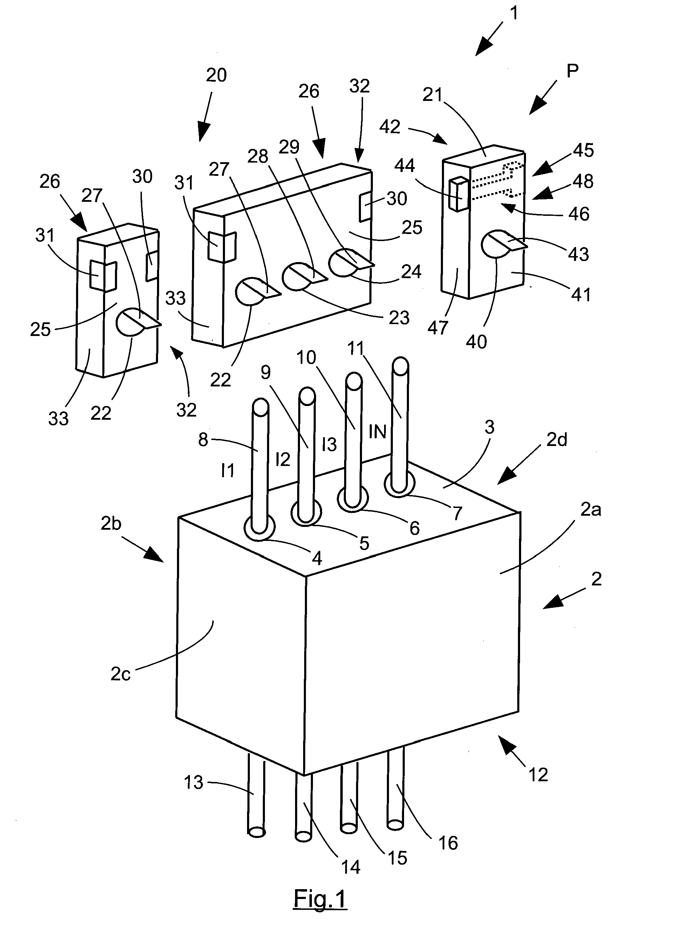

Sur la figure 1, on a représenté schématiquement un dispositif de mesure 1 d'au moins une grandeur électrique d'un courant circulant dans un appareil électrique 2. Les grandeurs électriques mesurées peuvent être par exemple, des courants ou des tensions. Plus particulièrement, le dispositif de mesure 1 est un compteur d'énergie configuré pour mesurer des tensions et des courants et pour calculer les énergies et puissances électriques, consommées ou fournies par l'appareil 2. L'appareil électrique 2 est de préférence un appareil de protection d'un système électrique situé en amont ou en aval de l'appareil 2. Par exemple, l'appareil 2 est un disjoncteur. En outre, l'appareil électrique 2 peut être un disjoncteur monophasé ou triphasé, avec ou sans neutre. Sur la figure 1, on a représenté un disjoncteur triphasé 2 avec neutre. Le disjoncteur 2 a une forme générale parallélépipédique et comporte une face avant 2a, une face arrière 2b, deux faces latérales 2c, 2d, et une première face de connexion 3 qui comporte une ou plusieurs bornes de connexion d'entrée 4 à 7 destinées à recevoir respectivement des conducteurs électriques 8 à 11. Dans l'exemple illustré, les trois premières bornes d'entrée 4 à 6 sont reliées électriquement aux trois conducteurs de phase d'entrée 8 à 10 dans lesquels circulent trois courants de phase I1 à I3 correspondants respectivement aux trois phases d'un courant triphasé. La quatrième borne d'entrée 7, également notée borne de référence d'entrée, est reliée électriquement au conducteur électrique 11 dans lequel circule le courant de neutre IN. Le conducteur électrique 11 est également noté conducteur de référence d'entrée. Dans l'exemple illustré à la figure 1, la borne de référence d'entrée 7 est située à droite des bornes de connexion d'entrée 4 à 6. D'autres disjoncteurs 2 peuvent avoir leur borne de référence d'entrée située à gauche des bornes de connexion d'entrée. Par ailleurs, le disjoncteur 2 comporte une deuxième face de connexion 12 opposée à la première face 3. La deuxième face 12 comporte également quatre bornes de connexion de sortie, non représentées à des fins de simplification, destinées à recevoir respectivement des conducteurs de sortie 13 à 16. Les trois premiers conducteurs de sortie 13 à 15 sont des conducteurs de phase parcourus par respectivement les trois courants de phase I1 à I3 et le quatrième conducteur de référence de sortie 16 est parcouru par le courant de neutre IN. Dans cette configuration, le courant qui circule dans l'appareil électrique 2, entre par les bornes d'entrée 4 à 7 et sort de l'appareil 2 par les bornes de sortie 13 à 16. D'autres disjoncteurs 2 peuvent avoir une autre configuration. Par exemple, l'appareil électrique 2 peut être un disjoncteur triphasé sans neutre ayant trois conducteurs de phase 8 à 10, ou un disjoncteur monophasé sans neutre avec un seul conducteur de phase 8, ou un disjoncteur monophasé avec neutre ayant un conducteur de phase 8 et un conducteur de référence 11. De manière générale il y a quatre configurations possibles de disjoncteurs. En outre, le dispositif de mesure 1 doit pouvoir être monté en amont ou en aval de chacun de ces disjoncteurs. Il y a donc huit possibilités pour placer le dispositif de mesure 1 sur un disjoncteur 2.

Le dispositif de mesure 1 comprend un module principal 20 et un module auxiliaire 21. Chaque module 20, 21 comporte un boîtier de forme générale parallélépipédique qui est électriquement isolant. Chaque module 20, 21 est en outre destiné à être monté sur l'appareil électrique 2. En particulier, chaque module 20, 21 est configuré pour être monté, soit en amont sur la première face 3 de l'appareil 2, soit en aval sur la deuxième face 12 de l'appareil 2.

Le module principal 20 comprend un ou plusieurs orifices traversant 22 à 24 des première et deuxième faces 25, 26 du module principal 20. Chaque orifice traversant 22 à 24 du module principal est destiné à être traversé par un conducteur de phase d'entrée 8 à 10, ou de sortie 13 à 15. Lorsque le module principale 20 comporte un unique orifice traversant 22, ce dernier peut être traversé par un des conducteurs de phase d'entrée 8 à 10, ou par un des conducteurs de phase de sortie 13 à 15. Selon une autre mode de réalisation, le module principal 20 comporte trois orifices traversant 22 à 24 destinés à être traversés par respectivement les trois conducteurs de phase d'entrée 8 à 10, ou respectivement les trois conducteurs de phase de sortie 15, 14 et 13. Chaque orifice traversant 22 à 24 comporte également des moyens de connexion 27 à 29, par exemple des fiches conductrices, configurés pour être reliés électriquement respectivement aux bornes de connexion d'entrée 4 à 6 ou aux bornes de connexion de sorties de l'appareil 2. Chaque fiche conductrice 27 à 29 est en saillie de l'orifice traversant 22 à 24 auquel elle appartient. En d'autres termes, chaque fiche conductrice 27 à 29 est en saillie de la première face 25 du boîtier du module principal 20. Chaque fiche conductrice 27 à 29 est également destinée à être insérée dans une borne de connexion d'entrée 4 à 6, ou de sortie 13 à 15 de l'appareil 2 pour être en contact électrique avec le conducteur qui est relié à ladite borne de connexion. Par ailleurs, chaque fiche conductrice 27 à 29 est configurée pour coopérer avec une borne de connexion d'entrée 4 à 6, ou de sortie 13 à 15, afin de maintenir le module principal 20 sur l'appareil 2. Les fiches conductrices 27 à 29 sont destinées à être vissées en même temps que les conducteurs de phase 8 à 10, sur les bornes de connexion de l'appareil 2. Le système de vis de serrage est intégré dans l'appareil 2. Chaque fiche conductrice 27 à 29 permet de prendre la tension au niveau de la borne de connexion avec laquelle elle coopère, et de maintenir le module principal 20 sur l'appareil 2 après introduction de la fiche 27 à 29 dans la borne.

Le module principal 20 comporte des première et deuxième connexions principales 30, 31 reliées électriquement entre elles. Les deux connexions principales 30, 31 sont situées respectivement sur deux faces latérales 32, 33 opposées du modules principal 20. Les deux faces latérales 32, 33 sont orientées sensiblement perpendiculairement aux première et deuxième faces 25, 26 du module principal 20. Chaque connexion principale 30, 31 est configurée pour être reliée électriquement à la borne de référence d'entrée 7, ou à la quatrième borne de sortie 16. Selon un mode de réalisation, la liaison électrique d'une connexion principale 30, 31 à une des bornes de référence de l'appareil 2 est réalisée par l'intermédiaire d'un conducteur électrique souple. Avantageusement, la liaison électrique est réalisée par l'intermédiaire du module auxiliaire 21.

Par exemple, on peut monter le module principal 20 comprenant trois orifices traversant 22 à 24 en amont d'un disjoncteur triphasé 2 en montant le module 20 de sorte que les trois orifices traversant 22 à 24 sont traversés par respectivement les trois conducteurs de phase 8 à 10. On peut également monter le même module principal 20 en aval du disjoncteur triphasé 2 de sorte que les trois orifices traversant 22 à 24 sont traversés par respectivement les trois conducteurs de phase 15, 14 et 13. Dans les deux configurations, amont ou aval, les fiches conductrices 27 à 29 sont insérées dans les bornes du disjoncteur 2 et sont également disposées en regard de la même face antérieure 2a du disjoncteur 2. En outre, quelle que soit la position du module principal 20, on peut connecter l'une des connexion principale 30, 31 à l'une des bornes de référence 7 de l'appareil 2.

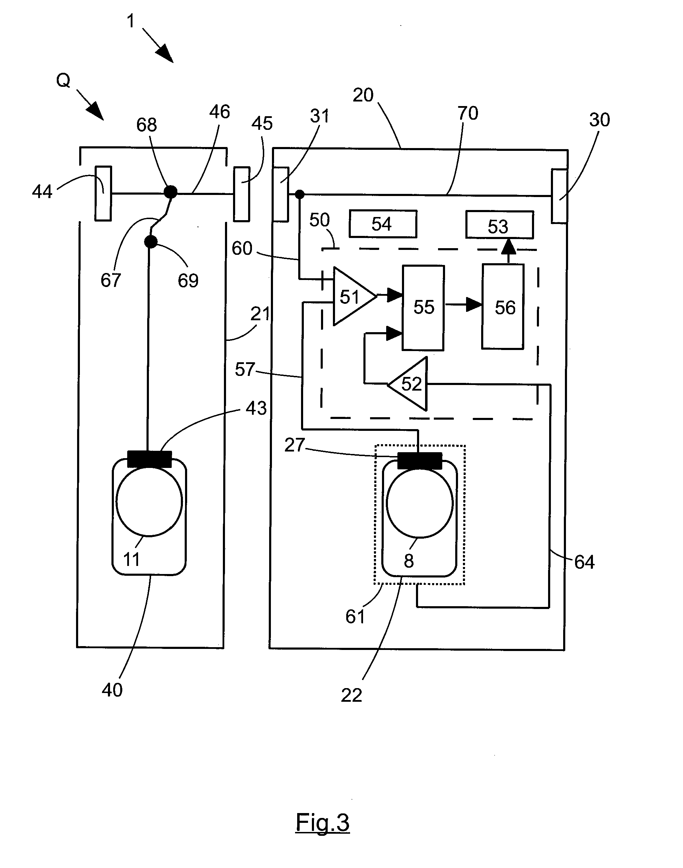

Le module auxiliaire 21 comporte, quant à lui, un unique orifice traversant 40 des première et deuxième faces 41, 42 du module auxiliaire 21. L'unique orifice traversant 40 du module auxiliaire 21 est destiné à être traversé par le conducteur de référence d'entrée 11 ou de sortie 16. Lorsque le module auxiliaire 21 est monté sur la première face de connexion 3 de l'appareil 2, l'unique orifice traversant 40 est traversé par le conducteur de référence d'entrée 11, et lorsqu'il est monté sur la deuxième face de connexion 12, l'unique orifice traversant 40 est traversé par le conducteur de référence de sortie 16. L'unique orifice traversant 40 comporte également des moyens de connexion 43, par exemple une fiche conductrice, configurés pour être reliés électriquement à la borne de connexion de référence d'entrée 7 ou à la borne de connexion de référence de sortie de l'appareil 2. La fiche conductrice 43 est en saillie de l'unique orifice traversant 40, c'est-à-dire qu'elle est en saillie de la première face 41 du boîtier du module principal 20. La fiche conductrice 43 est également configurée pour coopérer avec une borne de connexion de référence d'entrée 7, ou de sortie, afin de maintenir le module auxiliaire 21 sur l'appareil 2. La fiche conductrice 40 est destinée à être vissée en même temps que le conducteur de référence 11, 16, sur la borne de référence d'entrée 7 ou de sortie de l'appareil 2. Les systèmes de vis de serrage sont intégrés au niveau des bornes de référence de l'appareil 2. La fiche conductrice 43 permet de prendre la tension de référence au niveau de la borne de connexion de référence avec laquelle elle coopère, tout en maintenant le module auxiliaire 21 sur l'appareil 2 après introduction de la fiche 43 dans la borne. Le module auxiliaire 21 comporte des première et deuxième connexions auxiliaires 44, 45 reliées électriquement entre elles et aux moyens de connexion 43 du module auxiliaire 21. Chaque connexion auxiliaire 44, 45 est configurée pour coopérer avec l'une des deux connexions principales 30, 31 du module principale 20 de façon à relier électriquement la borne de référence, qui est elle même reliée électriquement aux moyens de connexion 43, avec l'une des connexions principales 30, 31. Selon un mode de réalisation préféré, les connexions auxiliaires 44, 45 sont situées respectivement aux extrémités d'un élément conducteur 46 monté mobile en translation entre une première position P, comme illustré sur la figure 1, et une deuxième position Q comme illustré sur la figure 3. L'élément conducteur mobile 46 est configuré pour se déplacer en translation à l'aide d'un rail prévu à l'intérieur du boîtier du module auxiliaire 21 et qui s'étend sensiblement parallèlement aux première et deuxième faces 41, 42 du module auxiliaire 21. En particulier, le module auxiliaire 21 comporte deux faces latérales 47, 48 orientées sensiblement perpendiculairement aux première et deuxième faces 41, 42 du module auxiliaire 21 et comprenant respectivement deux fentes. L'élément conducteur mobile 46 se déplace en translation sensiblement perpendiculairement aux deux faces latérales 47, 48. Chaque fente est configurée pour laisser passer une connexion auxiliaire 44, 45 en saillie du module auxiliaire 21. En outre, le dispositif de mesure 1 comporte un obturateur pour obturer la fente qui est située en regard d'une première connexion auxiliaire rétractée lorsque la deuxième connexion auxiliaire est en saillie pour être connectée à une connexion principale. L'obturateur permet d'éviter tout risque de contact électrique par un opérateur lorsque le module auxiliaire 21 est monté sur l'appareil 2. Lorsque l'élément conducteur mobile 46 est dans la première position P, la première connexion auxiliaire 44 est située en saillie du module auxiliaire 21 de manière à pouvoir coopérer avec la première connexion principale 30 et la deuxième connexion auxiliaire 45 est rétractée à l'intérieur du module auxiliaire 21. Dans cette première position P, la première connexion auxiliaire 44 est accessible et peut être connectée directement à la première connexion principale 30, et la deuxième connexion auxiliaire 45 n'est pas accessible et permet de diminuer l'encombrement autour de l'appareil électrique 2. Avantageusement, la fente située en regard de la deuxième connexion auxiliaire 45 est obturée par l'obturateur du dispositif de mesure 1. Inversement, lorsque l'élément conducteur mobile 46 est dans la deuxième position Q, la deuxième connexion auxiliaire 45 est située en saillie du module auxiliaire 21 de manière à pouvoir coopérer avec la deuxième connexion principale 31 et la première connexion auxiliaire 44 est rétractée à l'intérieur du module auxiliaire 21. Dans cette deuxième position Q, la deuxième connexion auxiliaire 45 est accessible et peut être connectée directement à la deuxième connexion principale 31, et la première connexion auxiliaire 44 n'est pas accessible. Dans la deuxième position Q, la fente située en regard de la première connexion auxiliaire 44 est obturée par l'obturateur du dispositif de mesure 1. Avantageusement, chaque connexion auxiliaire 44, 45 et chaque connexion principales 30, 31 sont en forme de queue d'aronde de façon à coopérer mécaniquement entre elles. Ainsi, chaque connexion auxiliaire 44, 45 peut établir une connexion mécanique avec au moins une connexion principale 30, 31 pour assurer un verrouillage du module auxiliaire 21 par rapport au module principal 20. Lorsque les modules auxiliaire 21 et principal 20 sont vissés, par l'intermédiaire de leurs fiches conductrices 27 à 29 et 43, sur l'appareil 2, on ne peut pas désolidariser les modules 20, 21 entre eux. Dans ce cas, on évite une déconnexion accidentelle des modules en cours de fonctionnement, lorsque par exemple le dispositif de mesure 1 et l'appareil 2 sont soumis à des vibrations pouvant être générées par un moteur en rotation à proximité de l'appareil électrique 2.

Par exemple, lorsque le module principal 20 comprenant trois orifices traversant 22 à 24 est monté en amont d'un disjoncteur triphasé 2, on peut monter le module auxiliaire 21 sur la borne de référence 7 du disjoncteur 2. Dans ce cas, l'élément conducteur 46 est dans la position P et la première connexion auxiliaire 44 est connectée à la première connexion principale 30. Lorsque le même module principal 20 est monté en aval du disjoncteur triphasé 2, le module auxiliaire est monté sur la borne de référence de sortie du disjoncteur. Dans ce cas, l'élément conducteur 46 est dans la position Q et la deuxième connexion auxiliaire 45 est connectée à la deuxième connexion principale 31.

Le module principal 20 comporte en outre des moyens de mesure de tension, des moyens de mesure de courant et des moyens de calcul d'énergie et de puissance électrique. Les moyens de mesure de tension sont reliés aux moyens de connexion 27 à 29 de chaque orifice traversant 22 à 24 et aux connexions principales 30, 31. Lorsque les connexions principales 30, 31 sont reliées électriquement à l'une des bornes de connexion de référence de l'appareil 2, les moyens de mesure de tension peuvent mesurer les tensions respectives des bornes de connexion d'entrée 4 à 6, ou des bornes de connexion de sortie par rapport à la borne de référence. Les moyens de mesure de courant sont reliés à des capteurs de courant intégrés au sein du module principal 20. Chaque capteur est configuré pour déterminer le courant qui circule dans l'un des conducteurs de phase.

Comme on peut le voir sur la figure 1, le conducteur de référence 11 est à droite des conducteurs de phase 8 à 10, et le conducteur de référence 16 est également à droite des conducteurs de phase de sortie 13 à 15 du disjoncteur 2. En raison de la position du conducteur de référence, et des positions des fiches conductrices qui sont figées, un même dispositif de mesure 1 est adapté pour être monté soit en amont, soit en aval de l'appareil électrique 2.

Le module auxiliaire 21 est amovible et peut être monté, soit à gauche, soit à droite du module principal 20.

A l'aide d'un tel dispositif, on peut réduire le nombre de modules à réaliser pour offrir une gamme complète de dispositifs de mesure adaptés aux différents appareils électriques. Par exemple, on pourra réaliser une gamme de dispositifs de mesure comprenant un premier dispositif de mesure comprenant un module principal 20 muni de trois orifices traversant et un module auxiliaire 21, et un deuxième dispositif de mesure comprenant un module principal 20 muni d'un unique orifice traversant. A l'aide du module auxiliaire amovible 21 adapté pour être couplé au module principal 20, à gauche ou à droite, on peut prendre la mesure de la tension d'un conducteur de neutre 11, 16. Ainsi, à l'aide d'uniquement trois types de modules, un module principal 20 ayant trois orifices traversant, un module principal 20 ayant un unique orifice traversant et un module auxiliaire 21, on peut facilement monter les différents dispositifs de mesure sur les différents appareils électriques.

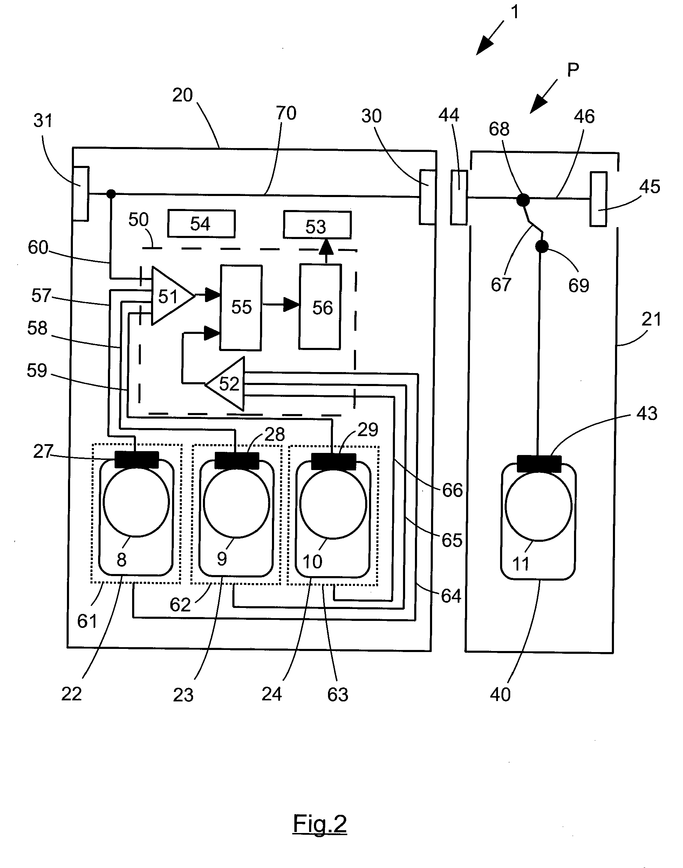

Sur la figure 2, on a représenté une vue schématique d'un mode de réalisation d'un dispositif de mesure 1. On a également reporté sur la figure 2 les références des différents éléments décrits à la figure 1. Le dispositif de mesure 1 comprend un module principal 20 muni des trois orifices traversant 22 à 24 et le module auxiliaire 21. Le module principal 20 comprend un module de traitement 50 comportant les moyens de mesure de tension 51 et les moyens de mesure de courant 52, un module de communication 53 et une unité d'alimentation 54 pour alimenter le module de traitement 50 et le module de communication 53. En outre, le module de traitement 50 comporte un convertisseur analogique/numérique 55 couplé aux moyens de mesure de tension 51 et de courant 52, et un module de calcul 56 couplé au convertisseur 55 et au module de communication 53. Le module de calcul 56 permet de calculer les énergies et puissances électriques à partir des valeurs des tensions et des courants mesurées. Le module de communication 53 transmet les grandeurs calculées à un afficheur qui peut être intégré au boîtier du module principal 20 ou qui peut être déporté sur un appareil extérieur au module principal 20. Les moyens de mesure de tension 51 sont, par ailleurs, couplés aux moyens de connexion 27 à 29 par des connexions respectives 57 à 59, et sont couplés aux connexions principales 30, 31 par une connexion 60. Le module principal 20 comporte également trois capteurs de courant 61 à 63, représentés en pointillés, reliés aux moyens de mesure de courant 52 par des connexions respectives 64 à 66. Les connexions principales 30, 31 sont reliées électriquement entre elles par une connexion 70 qui peut être une barre conductrice ou un circuit électronique.

Le module auxiliaire 21 comporte des moyens de liaison mobiles 67 couplés entre un première borne 68 montée fixe sur l'élément conducteur mobile 46 et une deuxième borne 69 montée fixe sur un conducteur électrique relié aux moyens de connexion 43 du module auxiliaire 21. Les moyens de liaison mobiles 67 permettent de relier électriquement les moyens de connexion 43 à l'élément conducteur mobile 46, c'est-à-dire aux connexions auxiliaires 44, 45. Par ailleurs, les moyens de liaison 67 sont mobiles pour conserver la liaison électrique lorsque l'élément conducteur 46 se déplace en translation. Les moyens de liaison mobiles 67 peuvent être un fil conducteur souple ou une lame ressort.

Un tel dispositif est adapté pour des disjoncteurs triphasés avec ou sans neutre. Lorsque le disjoncteur est sans neutre, le dispositif de mesure comporte avantageusement uniquement le module principal muni de trois orifices traversant. Au contraire, lorsque le disjoncteur est avec neutre, le dispositif de mesure comporte avantageusement le module principal muni de trois orifices traversant et le module auxiliaire couplé à gauche ou à droite du module principal.

Sur la figure 3, on a représenté une vue schématique d'un autre mode de réalisation d'un dispositif de mesure 1. On a également reporté sur la figure 3 les références des différents éléments décrits aux figures précédentes. Le dispositif de mesure 1 comprend un module principal 20 muni d'un unique orifice traversant 22 et le module auxiliaire 21. Dans ce mode de réalisation, l'élément conducteur mobile 46 est situé dans la deuxième position Q. Un tel dispositif est adapté pour des disjoncteurs monophasés avec ou sans neutre. Lorsque le disjoncteur est monophasé sans neutre, le dispositif de mesure 1 comporte avantageusement uniquement le module principal 20 muni d'un unique orifice traversant. Dans ce cas, l'une des connexions principales 30, 31 est reliée au neutre de l'armoire électrique avec un fil conducteur souple. Au contraire, lorsque le disjoncteur est monophasé avec neutre, le dispositif de mesure comporte avantageusement le module principal muni d'un unique orifice traversant et le module auxiliaire couplé à gauche ou à droite du module principal.

Un tel dispositif de mesure est particulièrement adapté à différents disjoncteurs d'une même famille de disjoncteurs, monophasé ou triphasé avec ou sans neutre. En outre, il est facile à installer car il ne nécessite pas de système de vis pour le fixer à un appareil électrique.

## Revendications

1. Dispositif de mesure d'au moins une grandeur électrique d'un courant circulant dans un appareil électrique (2), comprenant un module principal (20) destiné à être monté sur l'appareil électrique (2), le module principal (20) comprenant :
- au moins un orifice traversant (22 à 24) des première et deuxième faces (25, 26) du module principal (20) et destiné à être traversé par au moins un conducteur (8 à 10, 13 à 15) relié électriquement à au moins une borne de l'appareil électrique (2), ledit orifice traversant (22 à 24) comprenant des moyens de connexion (27 à 29) configurés pour être reliés électriquement à ladite borne,
- des moyens de mesure de tension reliés aux moyens de connexion (27 à 29) et configurés pour mesurer au moins une tension entre ladite borne et une borne de référence de l'appareil électrique, et
- deux connexions principales (30, 31) reliées électriquement entre elles et aux moyens de mesure de tension, les deux connexions principales (30, 31) étant situées respectivement sur deux faces latérales (32, 33) du module principal (20) orientées sensiblement perpendiculairement aux première et deuxième faces (25, 26),
le dispositif comportant un module auxiliaire (21) destiné à être monté sur l'appareil électrique (2) et comprenant un unique orifice traversant (40) des première et deuxième faces (41, 42) du module auxiliaire (21) et destiné à être traversé par un conducteur de référence (11, 16) relié électriquement à la borne de référence, l'unique orifice traversant (40) comprenant des moyens de connexion (43) configurés pour être reliés électriquement à la borne de référence, le module auxiliaire (21) comprenant deux connexions auxiliaires (44, 45) reliées électriquement entre elles et aux moyens de connexion du module auxiliaire (21), **caractérisé en ce que** les connexions auxiliaires (44, 45) sont situées respectivement aux extrémités d'un élément conducteur (46) monté mobile en translation entre une première position (P) dans laquelle une première connexion auxiliaire (44) est située en saillie du module auxiliaire (21) pour coopérer avec une première connexion principale (30) et la deuxième connexion auxiliaire (45) est rétractée à l'intérieur du module auxiliaire (21), et une deuxième position (Q) dans laquelle la deuxième connexion auxiliaire (45) est située en saillie du module auxiliaire (21) pour coopérer avec la deuxième connexion principale (31) et la première connexion auxiliaire (44) est rétractée à l'intérieur du module auxiliaire (21).

2. Dispositif selon la revendication 1, dans lequel le module principal (20) comporte trois orifices traversant (22 à 24) les première et deuxième faces (25, 26) et destinés à être traversés par respectivement trois conducteurs (8 à 10, 13 à 15) reliés électriquement à trois bornes de l'appareil électrique (2), chaque orifice traversant (22 à 24) comprenant des moyens de connexion (27 à 29) configurés pour être reliés électriquement à la borne reliée au conducteur traversant l'orifice, les moyens de mesure de tension étant en outre configurés pour mesurer les tensions respectives entre les trois bornes et la borne de référence.

3. Dispositif selon la revendication 1 ou 2, dans lequel le module auxiliaire (21) comporte deux faces latérales orientées sensiblement perpendiculairement aux première et deuxième faces (41, 42) du module auxiliaire (21) et comprenant respectivement deux fentes pour le passage d'une connexion auxiliaire (44, 45) située en saillie du module auxiliaire (21), et le dispositif de mesure comporte un obturateur pour obturer la fente située en regard d'une première connexion auxiliaire rétractée lorsque la deuxième connexion auxiliaire est connectée à une connexion principale (30, 31).

4. Dispositif selon l'une des revendications 1 à 3, dans lequel le module auxiliaire (21) comporte des moyens de liaisons mobiles (67) reliant électriquement les moyens de connexion (43) du module auxiliaire (21) avec l'élément conducteur (46) monté mobile en translation.

5. Dispositif selon la revendication 4, dans lequel les moyens de liaisons mobiles (67) sont un fil conducteur ou une lame ressort.

6. Dispositif selon l'une des revendications 1 à 5, dans lequel chaque connexion auxiliaire (44, 45) est configurée pour établir une connexion mécanique avec au moins une connexion principale (30, 31) de façon à solidariser le module auxiliaire (21) avec le module principal (20).

7. Dispositif selon l'une des revendications 1 à 6, dans lequel les connexions principales (30, 31) sont reliées électriquement entre elles par une barre conductrice ou un circuit électronique.

8. Dispositif selon l'une des revendications 1 à 7, dans lequel l'appareil électrique (2) est un appareil de protection électrique, et les bornes de l'appareil correspondent aux bornes d'entrée ou aux bornes de sortie du courant circulant dans l'appareil (2).

9. Dispositif selon l'une des revendications 1 à 8, dans lequel les moyens de connexion (27 à 29 et 43) de chaque orifice traversant (22 à 24, et 40) comportent une fiche conductrice faisant saillie de l'orifice traversant de manière à coopérer avec la borne reliée au conducteur qui traverse l'orifice traversant pour maintenir le module principal (20) sur l'appareil (2).

10. Dispositif selon l'une des revendications 2 à 9, dans lequel le module principal (20) comporte en outre des moyens de mesure de courant (52) configurés pour mesurer le courant circulant dans chaque conducteur (8 à 10, 13 à 15) traversant les orifices traversant (22 à 24) du module principal (20).

## Patentansprüche

1. Vorrichtung zum Messen mindestens einer elektrischen Größe eines Stroms, der in einem elektrischen Apparat (2) zirkuliert, die ein Hauptmodul (20) umfasst, das dazu bestimmt ist, an den elektrischen Apparat (2) montiert zu werden, wobei das Hauptmodul (20) umfasst:
- mindestens eine durchgehende Öffnung (22 bis 24) der ersten und zweiten Seite (25, 26) des Hauptmoduls (20), die dazu bestimmt ist, von mindestens einem Leiter (8 bis 10, 13 bis 15) durchquert zu werden, der elektrisch an mindestens eine Klemme des elektrischen Apparats (2) gelegt ist, wobei die durchgehende Öffnung (22 bis 24) Anschlussmittel (27 bis 29) umfasst, die so vorgesehen sind, dass sie elektrisch an die genannte Klemme gelegt werden können,
- Spannungsmessvorrichtungen, die an die Anschlussmittel (27 bis 29) gelegt und so vorgesehen sind, dass sie mindestens eine Spannung zwischen der genannten Klemme und einer Vergleichsklemme des elektrischen Apparats messen, und
- zwei Hauptanschlüsse (30, 31), die miteinander und mit den Spannungsmessvorrichtungen elektrisch verbunden sind, wobei die beiden Hauptanschlüsse (30, 31) jeweils an zwei Seitenflächen (32, 33) des Hauptmoduls (20) vorgesehen sind, die im Wesentlichen lotrecht zur ersten und zweiten Seite (25, 26) ausgerichtet sind,
wobei die Vorrichtung ein Hilfsmodul (21) umfasst, das dazu bestimmt ist, an den elektrischen Apparat (2) montiert zu werden, und das eine einzige durchgehende Öffnung (40) der ersten und zweiten Seite (41, 42) des Hilfsmoduls (21) umfasst und dazu bestimmt ist, von einem Vergleichsleiter (11, 16) durchquert zu werden, der elektrisch an die Vergleichsklemme gelegt ist, wobei die einzige durchgehende Öffnung (40) Anschlussmittel (43) aufweist, die so vorgesehen sind, dass sie elektrisch an die Vergleichsklemme gelegt werden können, wobei das Hilfsmodul (21) zwei Hilfsanschlüsse (44, 45) umfasst, die elektrisch miteinander und mit den Anschlussmitteln des Hilfsmoduls (21) verbunden sind, **dadurch gekennzeichnet, dass** die Hilfsanschlüsse (44, 45) jeweils an den Enden eines leitenden Elements (46) angeordnet sind, das translationsbeweglich montiert ist zwischen einer ersten Position (P), in der ein erster Hilfsanschluss (44) hervorstehend aus dem Hilfsmodul (21) angeordnet ist, um mit einem ersten Hauptanschluss (30) zusammenzuwirken, und der zweite Hilfsanschluss (45) in das Hilfsmodul (21) eingezogen ist, und einer zweiten Position (Q), in der der zweite Hilfsanschluss (45) aus dem Hilfsmodul (21) hervorstehend angeordnet ist, um mit dem zweiten Hauptanschluss (31) zusammenzuwirken, und der erste Hilfsanschluss (44) in das Hilfsmodul (21) eingezogen ist.

2. Vorrichtung nach Anspruch 1, bei der das Hauptmodul (20) drei Öffnungen (22 bis 24) umfasst, die durch die erste und zweite Seite (25, 26) hindurchgeführt und dazu bestimmt sind, von jeweils drei Stromleitern (8 bis 10, 13 bis 15), die elektrisch an drei Klemmen des elektrischen Apparats (2) gelegt sind, durchzogen zu werden, wobei jede durchgehende Öffnung (22 bis 24) Anschlussmittel (27 bis 29) umfasst, die so vorgesehen sind, dass sie elektrisch an die Klemme gelegt werden können, die an den Stromleiter gelegt ist, der die Öffnung durchquert, wobei die Spannungsmessvorrichtungen ferner so vorgesehen sind, dass sie die jeweiligen Spannungen zwischen den drei Klemmen und der Vergleichsklemme messen.

3. Vorrichtung nach Anspruch 1 oder 2, bei der das Hilfsmodul (21) zwei Seitenflächen umfasst, die im Wesentlichen lotrecht zur ersten und zweiten Seite (41, 42) des Hilfsmoduls (21) ausgerichtet sind und jeweils zwei Schlitze zur Durchführung eines Hilfsanschlusses (44, 45) umfassen, der hervorstehend aus dem Hilfsmodul (21) angeordnet ist, und die Messvorrichtung einen Verschluss zum Verschließen des Schlitzes umfasst, der sich gegenüber einem ersten Hilfsanschluss befindet, der eingezogen ist, wenn der zweite Hilfsanschluss an einen Hauptanschluss (30, 31) gelegt ist.

4. Vorrichtung nach einem der Ansprüche 1 bis 3, bei der das Hilfsmodul (21) bewegliche Verbindungsmittel (67) aufweist, die die Anschlussvorrichtungen (43) des Hilfsmoduls (21) elektrisch mit dem translationsbeweglich montierten leitenden Element (46) verbinden.

5. Vorrichtung nach Anspruch 4, bei der die beweglichen Verbindungsmittel (67) ein leitender Draht oder die Zunge einer Feder sind.

6. Vorrichtung nach einem der Ansprüche 1 bis 5, bei der jeder Hilfsanschluss (44, 45) so vorgesehen ist, dass er eine mechanische Verbindung mit mindestens einem Hauptanschluss (30, 31) aufbaut und so das Hilfsmodul (21) fest mit dem Hauptmodul (20) verbindet.

7. Vorrichtung nach einem der Ansprüche 1 bis 6, bei der die Hauptanschlüsse (30, 31) über einen Leiterstab oder eine elektronische Schaltung elektrisch miteinander verbunden sind.

8. Vorrichtung nach einem der Ansprüche 1 bis 7, bei der der elektrische Apparat (2) ein elektrisches Schutzschaltgerät ist und die Klemmen des Geräts den Ein- oder Ausgangsklemmen des in dem Apparat (2) zirkulierenden Stroms entsprechen.

9. Vorrichtung nach einem der Ansprüche 1 bis 8, bei der die Anschlussmittel (27 bis 29 und 43) jeder durchgehenden Öffnung (22 bis 24, und 40) einen leitenden Stecker aufweisen, der aus der durchgehenden Öffnung heraussteht und so mit der an den Stromleiter gelegten Klemme zusammenwirkt, der durch die durchgehende Öffnung geführt ist, um das Hauptmodul (20) am Gerät (2) zu halten.

10. Vorrichtung nach einem der Ansprüche 2 bis 9, bei der das Hauptmodul (20) ferner Strommessvorrichtungen (52) umfasst, die so vorgesehen sind, dass sie den Strom messen, der jeweils in den Stromleitern (8 bis 10, 13 bis 15) zirkuliert, die durch die durchgehenden Öffnungen (22 bis 24) des Hauptmoduls (20) geführt sind.

## Claims

1. Device for measuring at least one electrical quantity of a current circulating in an electrical apparatus (2), comprising a main module (20) designed to be mounted on the electrical apparatus (2), the main module (20) comprising:
- at least one opening (22 to 24) passing through first and second faces (25, 26) of the main module (20) and designed to be passed through by at least one conductor (8 to 10, 13 to 15) electrically connected to at least one terminal of the electrical apparatus (2), said through opening (22 to 24) comprising connection means (27 to 29) configured to be electrically connected to said terminal,
- voltage measurement means connected to the connection means (27 to 29) and configured to measure at least one voltage between said terminal and a reference terminal of the electrical apparatus, and
- two main connections (30, 31) electrically connected to one another and to the voltage measurement means, the two main connections (30, 31) being respectively located on two lateral faces (32, 33) of the main module (20) oriented substantially perpendicularly to the first and second faces (25, 26),
the device according comprising an auxiliary module (21) designed to be mounted on the electrical apparatus (2) and comprising a single opening (40) passing through first and second faces (41, 42) of the auxiliary module (21) and designed to be passed through by a reference conductor (11, 16) electrically connected to the reference terminal, the single through opening (40) comprising connection means (43) configured to be electrically connected to the reference terminal, the auxiliary module (21) comprising two auxiliary connections (44, 45) electrically connected to one another and to the connection means of the auxiliary module (21), **characterized in that** the auxiliary connections (44, 45) are located respectively at the ends of a conducting element (46) mounted movable in translation between a first position (P) in which a first auxiliary connection (44) is located salient from the auxiliary module (21) to cooperate with a first main connection (30) and the second auxiliary connection (45) is retracted inside the auxiliary module (21), and a second position (Q) in which the second auxiliary connection (45) is located salient from the auxiliary module (21) to cooperate with the second main connection (31) and the first auxiliary connection (44) is retracted inside the auxiliary module (21).

2. Device according to claim 1, wherein the main module (20) comprises three openings (22 to 24) passing through the first and second faces (25, 26) and designed to be passed through by respectively three conductors (8 to 10, 13 to 15) electrically connected to three terminals of the electrical apparatus (2), each through opening (22 to 24) comprising connection means (27 to 29) configured to be electrically connected to the terminal connected to the conductor passing through the opening, the voltage measurement means being further configured to measure the respective voltages between the three terminals and the reference terminal.

3. Device according to claim 1 or 2, wherein the auxiliary module (21) comprises two lateral faces oriented substantially perpendicularly to the first and second faces (41, 42) of the auxiliary module (21) and respectively comprising two slots for passage of an auxiliary connection (44, 45) located salient from the auxiliary module (21), and the measurement device comprises a shutter to close off the slot located facing a retracted first auxiliary connection when the second auxiliary connection is connected to a main connection (30, 31).

4. Device according to one of claims 1 to 3, wherein the auxiliary module (21) comprises movable link means (67) electrically connecting the connection means (43) of the auxiliary module (21) with the conducting element (46) mounted movable in translation.

5. Device according to claim 4, wherein the movable link means (67) are a conducting wire or a spring blade.

6. Device according to one of claims 1 to 5, wherein each auxiliary connection (44, 45) is configured to establish a mechanical connection with at least one main connection (30, 31) so as to secure the auxiliary module (21) with the main module (20).

7. Device according to one of claims 1 to 6, wherein the main connections (30, 31) are electrically connected to one another by a conducting bar or an electronic circuit.

8. Device according to one of claims 1 to 7, wherein the electrical apparatus (2) is an electrical protection apparatus, and the terminals of the apparatus correspond to the input terminals or to the output terminals of the current circulating in the apparatus (2).

9. Device according to one of claims 1 to 8, wherein the connection means (27 to 29 and 43) of each through opening (22 to 24, and 40) comprise a conducting connector salient from the through opening so as to cooperate with the terminal connected to the conductor which passes through the through opening to maintain the main module (20) on the apparatus (2).

10. Device according to one of claims 2 to 9, wherein the main module (20) further comprises current measurement means (52) configured to measure the current circulating in each conductor (8 to 10, 13 to 15) passing through the through openings (22 to 24) of the main module (20).
